# EUROPEAN PATENT APPLICATION

(11) **EP 2 617 754 A1**
(43) Date of publication of application: **24.07.2013**
(21) Application number: 10857120.9
(22) Date of filing: 13.09.2010
(51) Int. Cl.: C08G 61/12, H01L 51/00, H01L 51/42, H01L 51/46

(54) **FLUORENE CONTAINING ORGANIC SEMICONDUCTOR MATERIAL, PREPARATION METHOD AND USE THEREOF**

(71) Applicant: Ocean's King Lighting Science&Technology Co., Ltd., Guangdong 518054 (CN)
(72) Inventor: ZHOU, Mingjie, Guangdong 518054 (CN); HUANG, Jie, Guangdong 518054 (CN); HUANG, Jiale, Guangdong 518054 (CN)
(74) Representative: Michalski, Stefan
(86) International application number: PCT/CN2010/076838
(87) International publication number: WO 2012/034264

(57) **Abstract**

A fluorene-containing organic semiconductor material, preparation method and use thereof are provided. Said fluorene-containing organic semiconductor material has the following formula (P), wherein n is an integer of 1-100; m is an integer of 1-20; x and y are positive real number, and x + y = 1; R₁ and R₂ are respectively H, F, CN, C₁-C₄₀ linear or branched alkyl or alkoxyl, aryl or heteroaryl groups; R₃ is H, C₁-C₂₀ alkyl. Said fluorene organic semiconductor material has a high carrier mobility, strong light absorbency and broad light absorption region, which improves utilization ratio to the sunlight.

## Description

### FIELD OF THE INVENTION

The present disclosure relates to copolymer organic semiconductor materials, and more particularly relates to a fluorene-containing organic semiconductor material.

The present disclosure also relates to a preparation method of the fluorene-containing organic semiconductor material and use thereof.

### BACKGROUND OF THE INVENTION

The high-efficiency solar cells usually use inorganic semiconductors as raw material, however, the development of commercial applications of the major silicon solar cells are inhibited due to the complex production process, the pollution, the high energy consumption, and high cost. Therefore the preparation of low-cost, high-energy solar cells using the cheap materials has been a research hotspot and difficulty in the photovoltaic field. Organic semiconductor material, on the one hand, has a good environmental stability, low production cost, functional easy modulation, good flexibility and film forming properties, on the other hand, it has advantages such as relatively simple process, low temperature operation, low fabrication cost, such that it has drawn lots of attention, and it has become a cheap and attractive solar cell material. In addition, the potential advantages of organic solar cells include: capable of manufacturing in large area, flexible substrates can be used, environmentally friendly, portable, etc..

Although the organic solar cell has been rapidly developed, but its conversion efficiency is still much lower than that of the inorganic solar cell. The major constraints limiting its performance are: relatively low carrier mobility of the organic semiconductor device, the mismatch of the spectral response of the device with the solar radiation spectrum, the high photon flux of the red area is not utilized effectively and the low efficiency of electrode collection of the carrier and so on. In order to make practical applications of the organic solar cells and to develop new materials, the primary task is to significantly improve the energy conversion efficiency in this research field.

Fluorene has a planar molecules characteristic and a relatively rigid structure, therefore it has a stable chemical properties. In addition, it can be introduced by other branched chain via a chemical reaction in the 9-position, and it can be easily cross-coupled to transition metal on 2, 7-position, therefore it has a good chemical modification. Furthermore, it also has a relatively wider band gap and lower the HOMO level, excellent quantum efficiency, a hole transport properties, and film-forming properties, therefore fluorene and its derivatives are widely used in the photovoltaic materials.

Anthracene and derivatives have good stability and good film-forming properties; its UV-visible spectrum shows wide finger-peak absorption, thus help to improve the absorption of sunlight coverage. In addition, it has the appropriate carrier transport characteristics, and the hole mobility of its crystal form at room temperature is up to 3 cm²/V•s, thus it is an excellent organic semiconductor material. Although anthracene and its derivatives have been reported as the organic electroluminescent light emitting material, the study as organic photovoltaic material has rarely been reported, thus greatly limiting the application scope.

Thieno [3,4-c] pyrrol-4 ,6 - dione has a simple structure, the atomic positions in the molecule is relatively compact, and it has a symmetry structure. When it is used as a unit of fluorene-containing organic semiconductor material, it also has a strong electron-withdrawing effect. By introducing alkane chain to the pyrrolidine ring, the solubility and processability of the organic semiconductor materials containing fluorine conjugated polymer is increased. Nowadays, it has a broad application prospects in the field of organic photoelectric.

### SUMMARY OF THE INVENTION

One object of the present invention is to provide a fluorene-containing organic semiconductor material for solving the problems.

Another object of the present invention is to provide a preparation method of a fluorene-containing organic semiconductor material and a use of the fluorene-containing organic semiconductor material in the field of organic solar cell, organic electroluminescent devices, organic field effect transistor, an organic optical storage, organic non-linear device, and the organic laser devices, etc..

The fluorene-containing organic semiconductor material according the present invention is represented by the following formula (P):

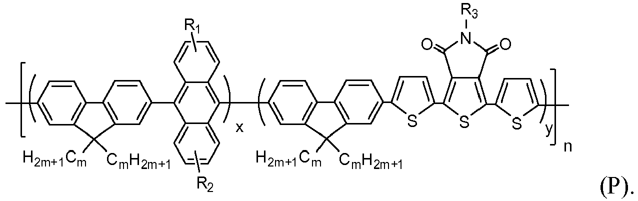

Wherein n is an integer of 1-100; m is an integer of 1-20; preferably, m is an integer of 6-12.

x and y are positive real numbers, and x + y = 1; x and y is determined by the feed ratio of 2,7 - bis (4,4,5,5 - tetramethyl-1 ,3,2 - dioxaborolanyl) -9,9 - dialkyl fluorene, 9,10-dibromoanthracene, and 1,3-bis (5-bromo-thiophene-yl) - thieno [3,4-c] pyrrol-4, 6-dione.

R₁ and R₂ may appear identical or different, each independently represents a functional group of the mono-or polysubstituted, they are respectively H, F, CN group, C₁-C₄₀ straight or branched alkyl or alkoxyl, aryl or heteroaryl groups; R₃ is H or C₁-C₂₀ alkyl, R₁ and R₂ are preferably C₁-C₁₈ linear or branched alkyl or alkoxyl.

R₃ is H or C₁-C₂₀ alkyl, preferably C₁-C₁₂ alkyl.

A preparation method of a fluorene-containing organic semiconductor material according the present invention includes the following steps:

Step one, 2, 7 - dibromo-9, 9 - dialkyl fluorene and n-butyl lithium (referred as n-Buli hereafter) or tert-butyl- lithium (t-BuLi) are added into a second solvent according to a mole ratio of 1:2 to 1:4 under anhydrous and anaerobic conditions at a temperature from -70°C to -85°C, and 2 - isopropoxy-4, 4, 5, 5 - tetramethyl-1, 3, 2-dioxaborolane or bis(pinacolato)diboron (the mole amount is 2 to 4 times of that of the 2, 7 - dibromo-9, 9 - dialkyl fluorene) is added, and reaction takes place for 12 to 48 hours, and the product, i.e. the 2,7 - bis (4,4,5,5 - tetramethyl-1 ,3,2 - dioxaborolanyl)-9,9 - dialkyl fluorene is obtained. The second solvent is at least one selected from the group consisting of tetrahydrofuran, diethyl ether, dichloromethane, chloroform, and ethyl acetate. The reaction formula is as follows:

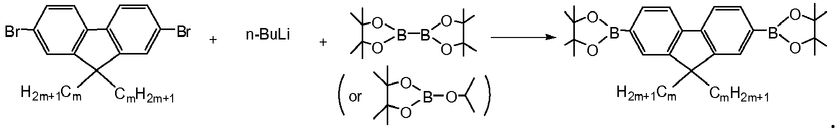

Step two, 2,7 - bis (4,4,5,5 - tetramethyl-1 ,3,2 - dioxaborolanyl)-9,9 - dialkyl fluorene represented by 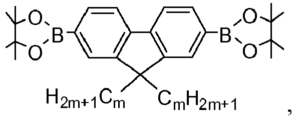 9,10-dibromoanthracene or derivatives thereof represented by 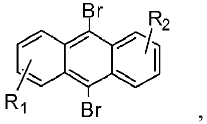 and 1,3-bis (5-bromo-thiophene-yl) - thieno [3,4-c] pyrrol-4, 6-dione and derivatives thereof represented by 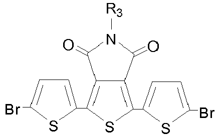 are mixed according to a mole ratio of i:j:k in the oxygen-free environment, wherein i=j+k; and i, j, k are positive real numbers, and a Suzuki reaction is performed for 24 to 72 hours at a temperature from 70°C to 100°C in the presence of catalyst, alkali solution, and a first solvent, and the fluorene-containing organic semiconductor material represented by 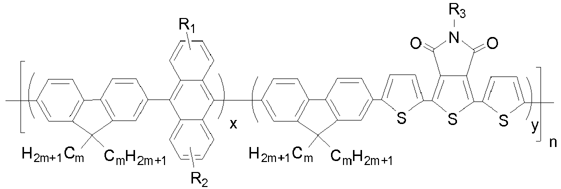 is obtained. The catalyst is Pd(PPh₃)₄, Pd(OAc)₂, tricyclohexylphosphine, Pd₂(dba)₃/P(o-Tol)₃ or Pd(PPh₃)₂Cl₂. The alkali solution is NaOH aqueous solution, Na₂CO₃ aqueous solution, NaHCO₃ aqueous solution, or tetraethyl ammonium hydroxide aqueous solution. The first solvent is at least one selected from the group consisting of toluene, ethylene glycol dimethyl ether, tetrahydrofuran, diethyl ether, dichloromethane, chloroform, and ethyl acetate. The mole amount of the catalyst is 0.01% to 20% of the mole amount of the 2, 7 - bis (4,4,5,5 - tetramethyl-1 ,3,2 - dioxaborolanyl)-9,9 - dialkyl fluorene. The mole amount of the alkali solution is 2 to 20 times of the mole amount of the 2, 7 - bis (4,4,5,5 - tetramethyl-1 ,3,2 - dioxaborolanyl)-9,9 - dialkyl fluorene. The reaction formula is as follows:

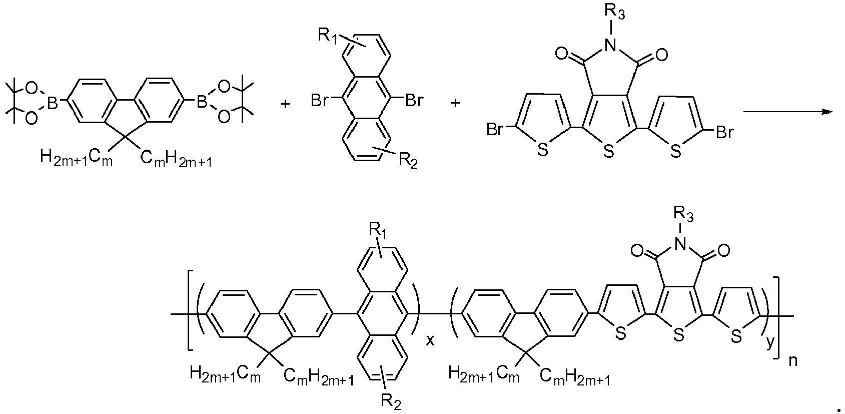

Compared with the prior art, the present invention has at least the following advantages:

1. Since anthracene and 1, 3 - bis (5 - bromo-thiophene-yl) - thieno [3,4-c] pyrrol-4 ,6 - dione groups are introduced in the molecule of the organic semiconductor material of the present invention, the carrier mobility performance and light absorption range are significantly improved.

2. Since the organic semiconductor material molecular contains anthracene, due to its excellent flatness and conjugate degree, the carrier mobility is improved. In addition, the alkyl modification is introduced to the 5-position of 1, 3- bis( 5- bromine thiophene ) - thiophene pyrrole and [3,4-c] -4,6- two ketone, thus improving its solubility and processing properties.

3. 1, 3- bis ( 5- bromine thiophene ) - thiophene pyrrole and [3,4-c] -4,6-two ketone has a simple structure, the atomic positions in the molecule is relatively compact, and it has a symmetry structure. When it is used as a unit of fluorene-containing organic semiconductor material, it also has a strong electron-withdrawing effect. Using 1,3 - bis (5 - bromo-thiophene-yl) - thieno [3,4-c] pyrrol-4 ,6 - dione unit and anthracene unit and fluorene unit to copolymerization, the band gap of the organic semiconductor material is effectively adjusted, and its absorption band is pushed toward the infrared and near infrared region, so that the absorbance becomes strong and light absorption range become wide, thus improving the utilization of sunlight, and the same time, the excellent performance and the charge transport properties of the organic semiconductor material is realized.

4. The organic semiconductor material preparation method has the advantages of simple process, high yield, mild reaction conditions, easy operation and control, and is suitable for industrialized production.

### BRIEF DESCRIPTION OF THE DRAWINGS

FIG. 1 is a schematic view of an organic solar cell device using organic semiconductor material of the present invention as an active layer;

FIG. 2 is a schematic view of an organic electroluminescent device using organic semiconductor material of the present invention as an active layer;

FIG. 3 is a schematic view of an organic field-effect transistor using organic semiconductor material of the present invention as an active layer.

### DETAILED DESCRIPTION

The present invention discloses a fluorene-containing organic semiconductor material represented by the following formula (P):

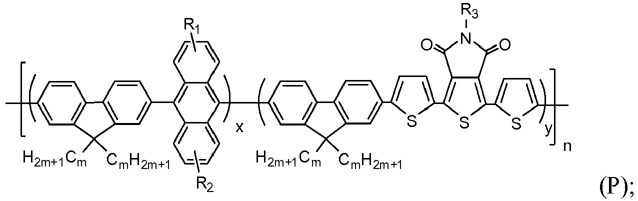

wherein n is an integer of 1-100; m is an integer of 1-20; preferably, m is an integer of 6-12.

x and y are positive real numbers, and x + y = 1; x and y is determined by the feed ratio of 2,7 - bis (4,4,5,5 - tetramethyl-1 ,3,2 - dioxaborolanyl)-9,9 - dialkyl fluorene, 9,10-dibromoanthracene, and 1,3-bis (5-bromo-thiophene-yl) - thieno [3,4-c] pyrrol-4, 6-dione.

R₁ and R₂ may appear identical or different, each independently represents a functional group of the mono-or polysubstituted, they are respectively H, F, CN group, C₁-C₄₀ straight or branched alkyl or alkoxyl, aryl or heteroaryl groups; R₃ is H or C₁-C₂₀ alkyl, R₁ and R₂ are preferably C₁-C₁₈ linear or branched alkyl or alkoxyl.

R₃ is H or C₁-C₂₀ alkyl, preferably C₁-C₁₂ alkyl.

A preparation method of a fluorene-containing organic semiconductor material includes the following steps:

Step S1, 2, 7 - dibromo-9, 9 - dialkyl fluorene and n-butyl lithium are added to a second solvent according to a mole ratio of 1:2 to 1:4 under anhydrous and anaerobic conditions at a temperature from -70°C to -85°C, and 2 - isopropoxy-4, 4, 5, 5 - tetramethyl-1, 3, 2- dioxaborolane or bis(pinacolato)diboron (its mole amount is 2 to 4 times of that of the 2, 7 - dibromo-9, 9 - dialkyl fluorene) is added, and reaction takes place for 12 to 48 hours, and the product, i.e. the 2,7 - bis (4,4,5,5 - tetramethyl-1 ,3,2 - dioxaborolanyl)-9,9 - dialkyl fluorene is obtained. The second solvent is at least one selected from the group consisting of tetrahydrofuran, diethyl ether, dichloromethane, chloroform, and ethyl acetate. The reaction formula is as follows: 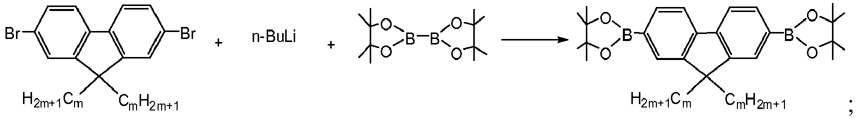 or

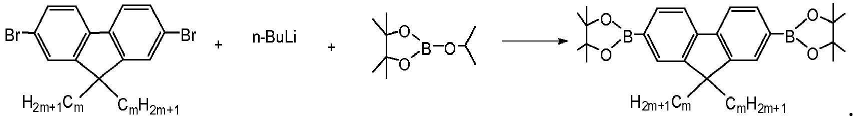

Step S2, 2,7 - bis (4,4,5,5 - tetramethyl-1 ,3,2 - dioxaborolanyl)-9,9 - dialkyl fluorene, 9,10-dibromoanthracene or derivatives thereof, and 1,3-bis (5-bromo-thiophene-yl) - thieno [3,4-c] pyrrol-4, 6-dione and derivatives thereof are mixed according to a mole ratio of i:j:k in the oxygen-free environment, wherein i=j+k; and i, j, k are positive real numbers, and a Suzuki reaction is performed for 24 to 72 hours at a temperature from 70°C to 100°C in the presence of catalyst, alkali solution, and a first solvent, and the fluorene-containing organic semiconductor material is obtained. The catalyst is Pd(PPh₃)₄, Pd(OAc)₂, tricyclohexylphosphine, Pd₂(dba)₃/P(*o*-Tol)₃ or Pd(PPh₃)₂Cl₂. The alkali solution is NaOH aqueous solution, Na₂CO₃ aqueous solution, NaHCO₃ aqueous solution, or tetraethyl ammonium hydroxide aqueous solution. The first solvent is at least one selected from the group consisting of toluene, ethylene glycol dimethyl ether, tetrahydrofuran, diethyl ether, dichloromethane, chloroform, and ethyl acetate. The mole amount of the catalyst is 0.01 % to 20% of the mole amount of the 2, 7 - bis (4,4,5,5 - tetramethyl-1 ,3,2 - dioxaborolanyl) -9,9 - dialkyl fluorene. The mole amount of the alkali solution is 2 to 20 times of the mole amount of the 2, 7 - bis (4,4,5,5 - tetramethyl-1 ,3,2 - two hetero oxopentyl borane) yl -9,9 - dialkyl fluorene. The reaction formula is as follows:

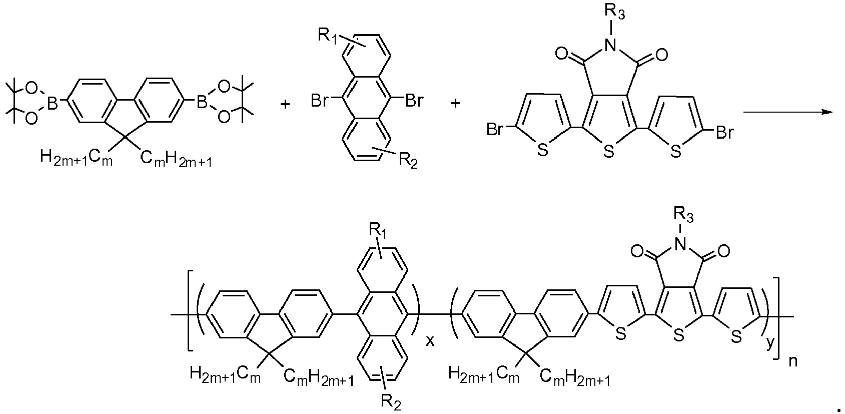

The oxygen-free environment of the present invention is provided by mixing nitrogen (N₂) and/or an inert gas.

The present invention develops a fluorene-containing organic semiconductor material and applies it in the organic solar cell and other fields. The material has a lower energy gap, higher mobility, and a wide absorption range of the spectrum, and the materials are conducive to the efficient transmission of the carrier within the active layer material. The material can be used to fabricate the organic solar cell as an active material, after the annealing at high temperature, it can effectively increase the order and regularity of the groups in the molecule and between the molecular chains segment, and it can improve the carrier mobility transmission speed and efficiency, thereby improving the photoelectric conversion efficiency.

The preferred examples will be described in further detail in accompany with the drawings.

Example 1

The fluorene-containing organic semiconductor material polymers P1 and P2 were disclosed as follows:

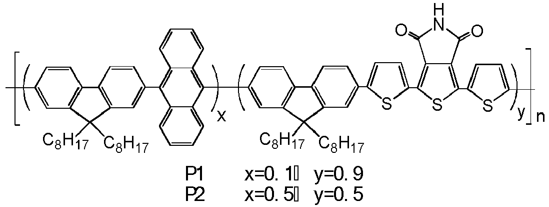

Preparation methods of P1 and P2 were described as follows:

Step one, preparation of 2,7 - bis (4,4,5,5 - tetramethyl-1 ,3,2 - dioxaborolanyl)-9,9 - dioctylfluorene.

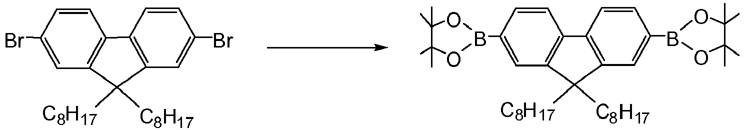

Anhydrous and anaerobic reactor was assembled, 9.0 mmol of white 2, 7 - dibromo-9 ,9 - dioctylfluorene was added to a three-necked flask under constant stirring and N₂ protection, 150ml of refined tetrahydrofuran solvent was added by syringe, 27.0 mmol n-BuLi was slowly added by syringe at -78°C, the mixture is stirred and reacted for 2 hours. 2 hours later, 2 - isopropoxy-4 ,4,5,5 - tetramethyl-1 ,3,2 - dioxaborolane was added by syringe at -78°C, the mixture was warmed to room temperature and placed overnight.

After completion of the reaction, saturated aqueous NaCl was added, and extracted with chloroform, dried with anhydrous sodium sulfate, after suction filtration, the filtrate was collected and the solvent was removed by rotary evaporation. The crude product was finally applied to silica gel column chromatography using petroleum ether and ethyl acetate (v / v = 15:1) as eluent, a powdery solid 2,7 - bis (4,4,5,5 - tetramethyl-1 ,3,2 - dioxaborolanyl)-9,9 - dioctylfluorene was obtained with the yield 65%. GC-MS (EI-m/z): 642 (M⁺).

Step two, preparation of P1 and P2:

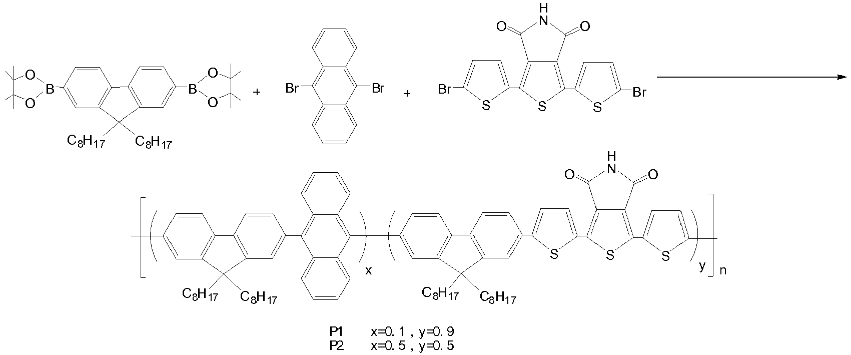

1mmol of 2,7 - bis (4,4,5,5 - tetramethyl-1 ,3,2 - dioxaborolanyl)-9,9 - dioctylfluorene, 0,1mmol of 9,10 - dibromoanthracene, 0.9mmol of 1,3 - bis (5 - bromo-thiophene-yl) - thieno [3,4-c] pyrrol-4 ,6 - dione, 0.025mmol of Pd₂(dba)₃, 0.050 mmol of P(o-Tol)₃, 5ml of 2mol/L Na₂CO₃ aqueous solution, and 30ml of toluene solvent were added into a reactor, the reaction system was kept in the anaerobic condition by repeatedly introducing N₂ and vacuuming, and was reacted for 70h at 70°C.

After the reaction for 70h, deionized water and toluene was added to the reaction flask containing product for extraction, the organic phase was extracted, the fluorene-containing organic semiconductor material polymer/toluene solution was evaporated to approximately 5ml with a vacuum distillation method. The solution was added dropwise to 300ml of anhydrous methanol with stirring, and a solid was precipitated, suction filtered, dried to obtain a solid powder. The solid powder was resolved in chloroform, applied to neutral alumina column chromatography to remove the catalyst (Pd₂(dba)₃/P(*o*-Tol)₃), the fluorene-containing organic semiconductor material polymer/toluene solution was evaporated to approximately 5ml. The solution was added dropwise to methanol solvent with stirring for a few hours, the fluorene-containing organic semiconductor material polymer P1 was finally collected and dried. The fluorene-containing organic semiconductor material was extracted with a Soxhlet extractor, thereby increasing the monodisperse of molecular weight of the fluorene-containing organic semiconductor material.

The purified fluorene-containing organic semiconductor material polymer P1 was dissolved in refined tetrahydrofuran to prepare a solution with a concentration of 1mg/1mL using Waters Breeze gel chromatography, after the insolubles were filtered off with a special instrument supporting membrane, the GPC test was carried out with 10 µL, 1mL/min. The number average molecular weight Mn≈69000, the monodisperse of fluorene-containing polymer organic semiconductor material is 1.31, and n is 100.

1mmol of 2,7 - bis (4,4,5,5 - tetramethyl-1,3,2 - dioxaborolanyl)-9,9 - dioctylfluorene, 0.5mmol of 9,10 - dibromoanthracene, 0.5mmol of 1,3 - bis (5 - bromo-thiophene-yl) - thieno [3,4-c] pyrrol-4 ,6 - dione were added into a reactor, other feeding amount of reagents, reaction conditions and post-treatment method are unchanged, and then the fluorene-containing organic semiconductor material polymer P2 was obtained. The purified fluorene-containing organic semiconductor material polymer P2 was dissolved in refined tetrahydrofuran to prepare a solution with a concentration of 1mg/1mL using Waters Breeze gel chromatography, after the insolubles were filtered off with a special instrument supporting membrane, the GPC test was carried out with 10 µL, 1mL/min. The number average molecular weight Mn≈41200, the monodisperse of fluorene-containing polymer organic semiconductor material is 1.46, and n is 65.

Example 2

The fluorene-containing organic semiconductor material polymers P3 and P4 were disclosed as follows:

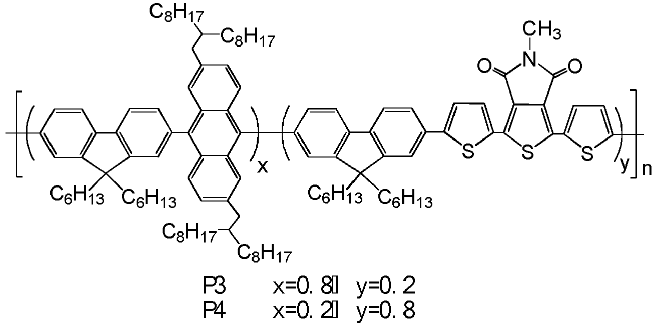

Preparation methods of P3 and P4 were described as follows:

Step one, preparation of 2,7 - bis (4,4,5,5 - tetramethyl-1 ,3,2 - dioxaborolanyl)-9,9 - dioctylfluorene.

The preparation process was similar to the steps in Example 1, but using argon to build the anaerobic protection environmental.

Step three, preparation of P3 and P4:

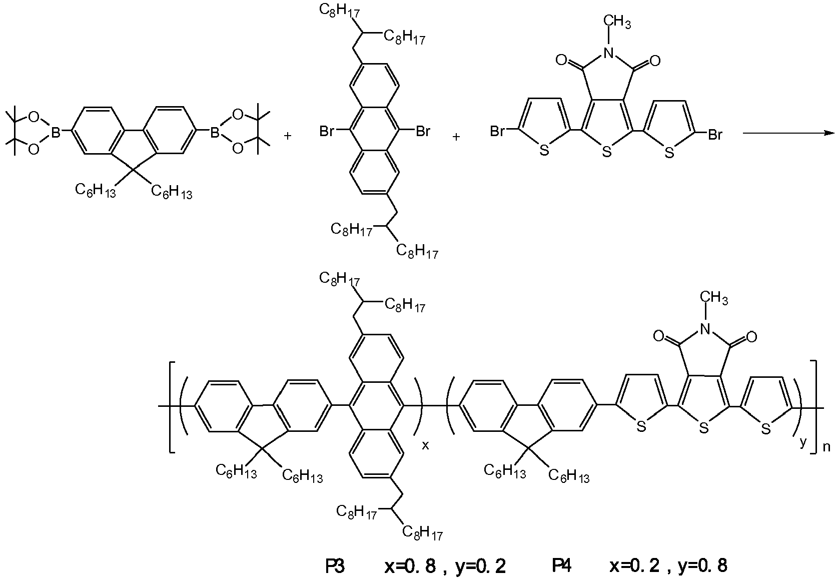

1mmol of 2,7 - bis (4,4,5,5 - tetramethyl-1 ,3,2 - dioxaborolanyl)-9,9 - dioctylfluorene, 0.8mmol of 9,10 - dibromo-2 ,6 - bis(2 - octyldecyl) anthracene (The synthesis method refers to Klaus Mullen, et al, Macromol. Chem. Phys. 2006, 207, 1107-1115), 0.2mmol of 1,3 - bis (5 - bromo-thiophene-yl) -5 - methyl- thiophene [3,4-c] pyrrol-4 ,6 - dione, 3mg of Pd(OAc)₂, 10m of 2mol/L Na₂CO₃ aqueous solution, and 40ml of toluene solvent were added into a reactor, the reaction system was kept in the anaerobic condition by repeatedly introducing N₂ and vacuuming, and was reacted for 24h at 100°C.

After the reaction for 24h, deionized water and toluene was added to the reaction flask containing product for extraction, the organic phase was extracted, the fluorene-containing organic semiconductor material polymer/toluene solution was evaporated to a small amount with a vacuum distillation method. The solution was added dropwise to 300ml of anhydrous methanol with stirring, and a solid was precipitated, suction filtered, dried to obtain a solid powder. The solid powder was resolved in chloroform, applied to neutral alumina column chromatography to remove the catalyst (Pd(OAc)₂), the fluorene-containing organic semiconductor material polymer/toluene solution was evaporated to approximately 5ml. The solution was added dropwise to methanol solvent with stirring for a few hours, the fluorene-containing organic semiconductor material polymer P3 was finally collected and dried. The fluorene-containing organic semiconductor material was extracted with a Soxhlet extractor, thereby increasing the monodisperse of molecular weight of the fluorene-containing organic semiconductor material.

The purified fluorene-containing organic semiconductor material polymer P3 was dissolved in refined tetrahydrofuran to prepare a solution with a concentration of 1mg/1mL using Waters Breeze gel chromatography, after the insolubles were filtered off with a special instrument supporting membrane, the GPC test was carried out with 10 µL, 1mL/min. The number average molecular weight Mn≈38500, the monodisperse of fluorene-containing polymer organic semiconductor material is 1.87, and n is 38.

1mmol of 2,7 - bis (4,4,5,5 - tetramethyl-1,3,2 - dioxaborolanyl)-9,9 - dioctylfluorene, 0.2mmol of 9,10 - dibromo-2 ,6 - bis (2 - octyldecyl) anthracene, 0.8mmol of 1,3 - bis (5 - bromo-thiophene-yl) - thieno [3,4-c] pyrrol-4 ,6 - dione were added into a reactor, other feeding amount of reagents, reaction conditions and post-treatment method are unchanged, and then the fluorene-containing organic semiconductor material polymer P4 was obtained. The purified fluorene-containing organic semiconductor material polymer P4 was dissolved in refined tetrahydrofuran to prepare a solution with a concentration of 1mg/1mL using Waters Breeze gel chromatography, after the insolubles were filtered off with a special instrument supporting membrane, the GPC test was carried out with 10 µL, 1mL/min. The number average molecular weight Mn≈31500, the monodisperse of fluorene-containing polymer organic semiconductor material is 2.03, and n is 43.

Example 3

The fluorene-containing organic semiconductor material polymers P5 and P5 were disclosed as follows:

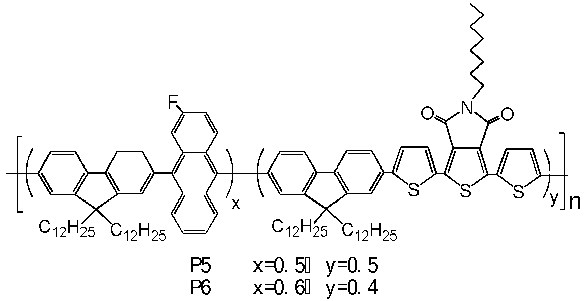

Preparation methods of P5 and P6 were described as follows:

Step one, preparation of 2,7 - bis (4,4,5,5 - tetramethyl-1 ,3,2 - dioxaborolanyl) -9,9 - dioctylfluorene.

The preparation process was similar to the steps in Example 1, but using mixture of nitrogen and argon to build the anaerobic protection environmental.
Step two, preparation of P5 and P6:

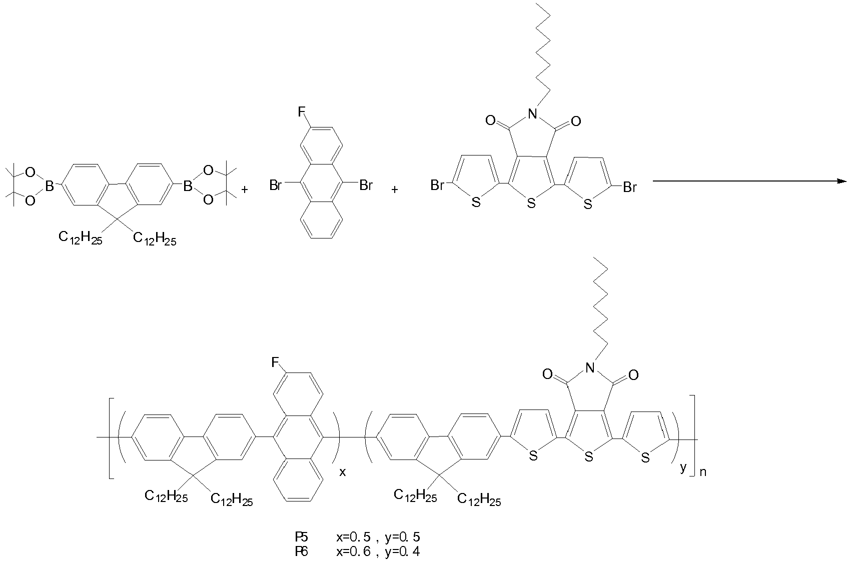

1mmol of 2,7 - bis (4,4,5,5 - tetramethyl-1 ,3,2 - dioxaborolanyl)-9,9 - dioctylfluorene, 0.5mmol of 9,10 - dibromo-2 - fluoroanthracene (The synthesis method refers to Elimelech Rochlin, et al, J.Org.Chem., 2003, 68, 216-226), 0.5mmol of 1,3 - bis (5 - bromo-thiophene-yl) -5 - methyl- thiophene [3,4-c] pyrrol-4 ,6 - dione, 0.02mmol of Pd(PPh)₃, 10m of 2mol/L Na₂CO₃ aqueous solution, and 40ml of toluene solvent were added into a reactor, the reaction system was kept in the anaerobic condition by repeatedly introducing N₂ and vacuuming, and was reacted for 58h at 80°C.

After the reaction for 58h, deionized water and toluene was added to the reaction flask containing product for extraction, the organic phase was extracted, the fluorene-containing organic semiconductor material polymer/toluene solution was evaporated to a small amount with a vacuum distillation method. The solution was added dropwise to 300ml of anhydrous methanol with stirring, and a solid was precipitated, suction filtered, dried to obtain a solid powder. The solid powder was resolved in chloroform, applied to neutral alumina column chromatography to remove the catalyst (Pd(PPh)₃), the fluorene-containing organic semiconductor material polymer/toluene solution was evaporated to approximately 5ml. The solution was added dropwise to methanol solvent with stirring for a few hours, the fluorene-containing organic semiconductor material polymer P5 was finally collected and dried. The fluorene-containing organic semiconductor material was extracted with a Soxhlet extractor, thereby increasing the monodisperse of molecular weight of the fluorene-containing organic semiconductor material.

The purified fluorene-containing organic semiconductor material polymer P5 was dissolved in refined tetrahydrofuran to prepare a solution with a concentration of 1mg/1mL using Waters Breeze gel chromatography, after the insolubles were filtered off with a special instrument supporting membrane, the GPC test was carried out with 10 µL, 1mL/min. The number average molecular weight Mn≈20300, the monodisperse of fluorene-containing polymer organic semiconductor material is 2.33, and n is 25. 1mmol of 2,7 - bis (4,4,5,5 - tetramethyl-1,3,2 - dioxaborolanyl)-9,9 - dioctylfluorene, 0.6mmol of 9,10 - dibromo-2 - fluoroanthracene, 0.4mmol of 1,3 - bis (5 - bromo-thiophene-yl) - thieno [3,4-c] pyrrol-4 ,6 - dione were added into a reactor, other feeding amount of reagents, reaction conditions and post-treatment method are unchanged, and then the fluorene-containing organic semiconductor material polymer P6 was obtained. The purified fluorene-containing organic semiconductor material polymer P6 was dissolved in refined tetrahydrofuran to prepare a solution with a concentration of 1mg/1mL using Waters Breeze gel chromatography, after the insolubles were filtered off with a special instrument supporting membrane, the GPC test was carried out with 10 µL, 1mL/min. The number average molecular weight Mn≈21300, the monodisperse of fluorene-containing polymer organic semiconductor material is 2.16, and n is 27.

Example 4

The fluorene-containing organic semiconductor material polymers P7 and P7 were disclosed as follows:

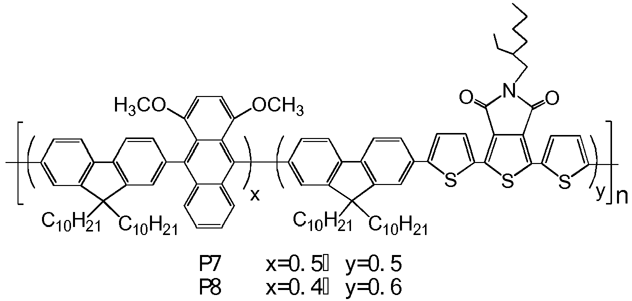

Preparation methods of P7 and P8 were described as follows:

Step one, preparation of 2,7 - bis (4,4,5,5 - tetramethyl-1 ,3,2 - dioxaborolanyl) -9,9 - dioctylfluorene.

The preparation process was similar to the steps in Example 1.

Step two, preparation of P7 and P8:

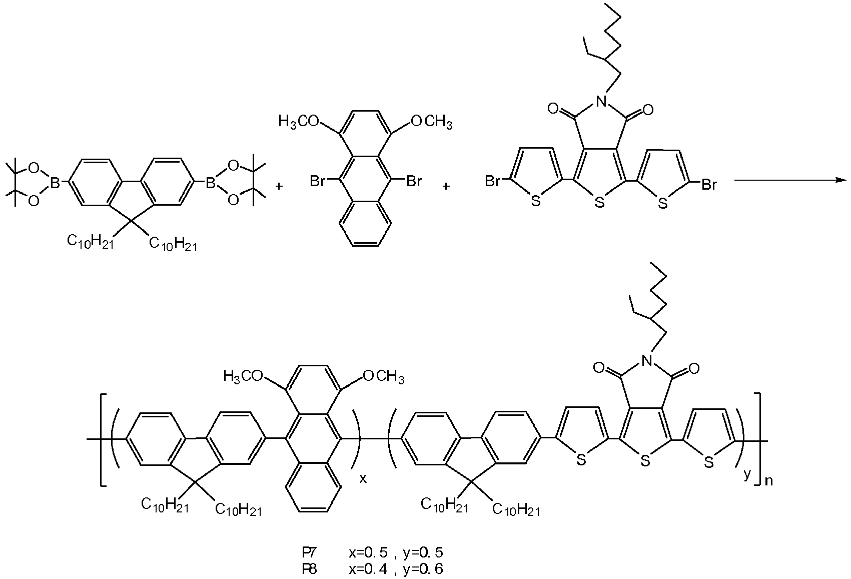

1mmol of 2,7 - bis (4,4,5,5 - tetramethyl-1 ,3,2 - dioxaborolanyl)-9,9 - dioctylfluorene, 0.5mmol of 9,10 - dibromo-1 ,4 - dimethoxyanthracene (The synthesis method refers to Osman Cakmak et al, J.Org.Chem., 2006, 71, 1795-1801), 0.5mmol of 1,3 - bis (5 - bromo-thiophene-yl) -5 - methyl - thiophene [3,4-c] pyrrol-4 ,6 - dione, 5mg of tricyclohexylphosphine, 10ml of 2mol/L Na₂CO₃ aqueous solution, and 40ml of toluene solvent were added into a reactor, the reaction system was kept in the anaerobic condition by repeatedly introducing N₂ and vacuuming, and was reacted for 64h at 90°C.

After the reaction for 64h, deionized water and toluene was added to the reaction flask containing product for extraction, the organic phase was extracted, the fluorene-containing organic semiconductor material polymer/toluene solution was evaporated to a small amount with a vacuum distillation method. The solution was added dropwise to 300ml of anhydrous methanol with stirring, and a solid was precipitated, suction filtered, dried to obtain a solid powder. The solid powder was resolved in chloroform, applied to neutral alumina column chromatography to remove the catalyst (tricyclohexylphosphine), the fluorene-containing organic semiconductor material polymer/toluene solution was evaporated to approximately 5ml. The solution was added dropwise to methanol solvent with stirring for a few hours, the fluorene-containing organic semiconductor material polymer P7 was finally collected and dried. The fluorene-containing organic semiconductor material was extracted with a Soxhlet extractor, thereby increasing the monodisperse of molecular weight of the fluorene-containing organic semiconductor material.

The purified fluorene-containing organic semiconductor material polymer P7 was dissolved in refined tetrahydrofuran to prepare a solution with a concentration of 1mg/1mL using Waters Breeze gel chromatography, after the insolubles were filtered off with a special instrument supporting membrane, the GPC test was carried out with 10 µL, 1mL/min. The number average molecular weight Mn≈56700, the monodisperse of fluorene-containing polymer organic semiconductor material is 1.43, and n is 73.

1mmol of 2,7 - bis (4,4,5,5 - tetramethyl-1,3,2 - dioxaborolanyl)-9,9 - dioctylfluorene, 0.4mmol of 9,10 - dibromo-1 ,4 - dimethoxyanthracene, 0.6mmol of 1,3 - bis (5 - bromo-thiophene-yl) - thieno [3,4-c] pyrrol-4 ,6 - dione were added into a reactor, other feeding amount of reagents, reaction conditions and post-treatment method are unchanged, and then the fluorene-containing organic semiconductor material polymer P8 was obtained. The purified fluorene-containing organic semiconductor material polymer P8 was dissolved in refined tetrahydrofuran to prepare a solution with a concentration of 1mg/1mL using Waters Breeze gel chromatography, after the insolubles were filtered off with a special instrument supporting membrane, the GPC test was carried out with 10 µL, 1mL/min. The number average molecular weight Mn≈47700, the monodisperse of fluorene-containing polymer organic semiconductor material is 1.31, and n is 60.

Example 5

The fluorene-containing organic semiconductor material polymers P9 and P10 were disclosed as follows:

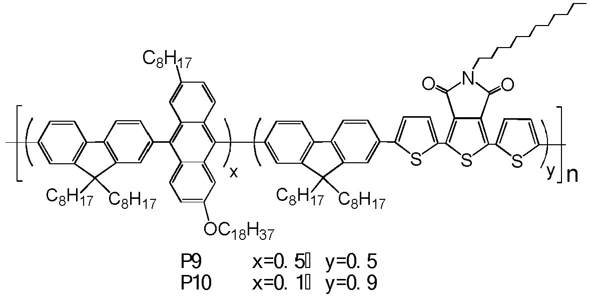

Preparation methods of P9 and P10 were described as follows:

The preparation process was similar to the steps in Example 1.

Step two, preparation of P9 and P 10:

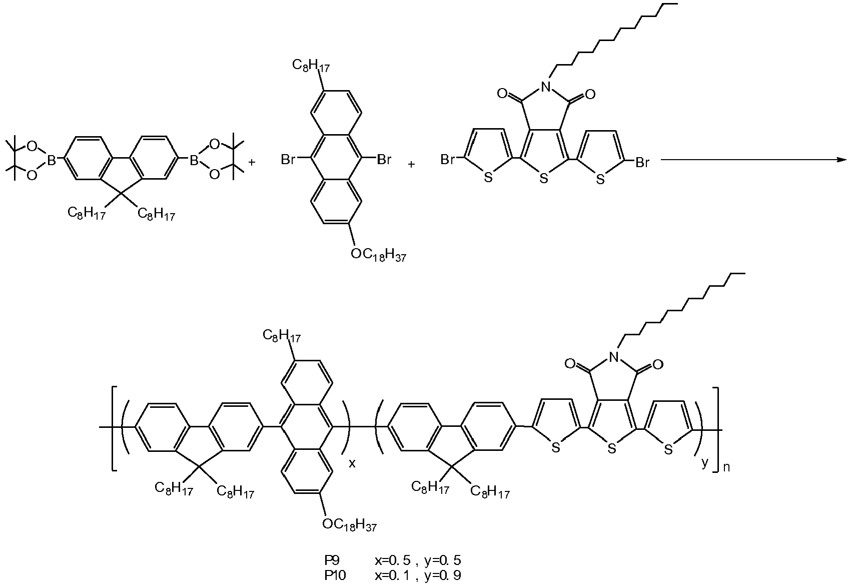

1mmol of 2,7 - bis (4,4,5,5 - tetramethyl-1 ,3,2 - dioxaborolanyl) -9,9 - dioctylfluorene, 0.5mmol of 9,10 - dibromo - 2 - octyl-6 - 18 alkoxy anthracene, 0.5mmol of 1,3 - bis (5 - bromo-thiophene-yl) -5 - methyl - thiophene [3,4-c] pyrrol-4 ,6 - dione, 0.02mmol of Pd(PPh₃)Cl₂, 10m of 2mol/L Na₂CO₃ aqueous solution, and 40ml of toluene solvent were added into a reactor, the reaction system was kept in the anaerobic condition by repeatedly introducing N₂ and vacuuming, and was reacted for 40h at 75°C.

After the reaction for 40h, deionized water and toluene was added to the reaction flask containing product for extraction, the organic phase was extracted, the fluorene-containing organic semiconductor material polymer/toluene solution was evaporated to a small amount with a vacuum distillation method. The solution was added dropwise to 300ml of anhydrous methanol with stirring, and a solid was precipitated, suction filtered, dried to obtain a solid powder. The solid powder was resolved in chloroform, applied to neutral alumina column chromatography to remove the catalyst (Pd(PPh₃)Cl₂), the fluorene-containing organic semiconductor material polymer/toluene solution was evaporated to approximately 5ml. The solution was added dropwise to methanol solvent with stirring for a few hours, the fluorene-containing organic semiconductor material polymer P9 was finally collected and dried. The fluorene-containing organic semiconductor material was extracted with a Soxhlet extractor, thereby increasing the monodisperse of molecular weight of the fluorene-containing organic semiconductor material.

The purified fluorene-containing organic semiconductor material polymer P9 was dissolved in refined tetrahydrofuran to prepare a solution with a concentration of 1mg/1mL using Waters Breeze gel chromatography, after the insolubles were filtered off with a special instrument supporting membrane, the GPC test was carried out with 10 µL, 1mL/min. The number average molecular weight Mn≈30000, the monodisperse of fluorene-containing polymer organic semiconductor material is 1.83, and n is 33.

1mmol of 2,7 - bis (4,4,5,5 - tetramethyl-1,3,2 - dioxaborolanyl) -9,9 - dioctylfluorene, 0.1 mmol of 9,10 - dibromo - 2 - octyl-6 - 18 alkoxy anthracene, 0.9mmol of 1,3 - bis (5 - bromo-thiophene-yl) - thieno [3,4-c] pyrrol-4 ,6 - dione were added into a reactor, other feeding amount of reagents, reaction conditions and post-treatment method are unchanged, and then the fluorene-containing organic semiconductor material polymer P10 was obtained. The purified fluorene-containing organic semiconductor material polymer P10 was dissolved in refined tetrahydrofuran to prepare a solution with a concentration of 1mg/1mL using Waters Breeze gel chromatography, after the insolubles were filtered off with a special instrument supporting membrane, the GPC test was carried out with 10 µL, 1mL/min. The number average molecular weight Mn≈26400, the monodisperse of fluorene-containing polymer organic semiconductor material is 2.01, and n is 30.

The present invention further provides the use of fluorene-containing organic semiconductor material, represented by the following formula (P): 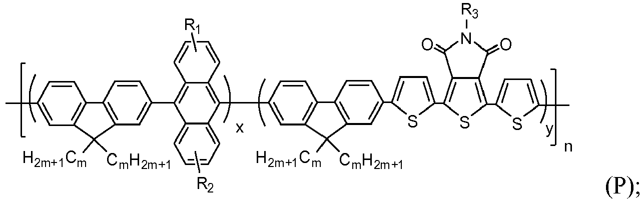 (wherein n is an integer of 1-100; m is an integer of 1-20; x and y are positive real numbers, and x + y = 1; R₁ and R₂ are respectively H, F, CN group, C₁-C₄₀ straight or branched alkyl or alkoxyl, aryl or heteroaryl groups; R₃ is H or C₁-C₂₀ alkyl) in the field of organic solar cell, organic electroluminescent devices, organic field effect transistor, an organic optical storage, organic non-linear device, and the organic laser devices, etc.

The following Examples are the use of the fluorene-containing organic semiconductor material in organic solar cell, organic field effect transistor, or organic electroluminescent device.

Example 6

An organic solar cell device is disclosed using P1 of Example 1 as the material of the active layer.

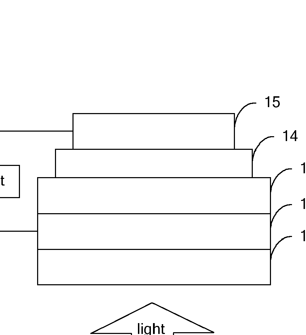

An organic solar cell device had a structure shown in FIG. 1. In the organic solar cell device, the substrate was ITO glass, in which glass was used as substrate base, ITO as the conductive layer.

The structure of the organic solar cell device was shown as: glass 11/ITO layer 12/PEDOT:PSS layer 13/active layer 14/ Al layer 15, where the material of the active layer was a mixture containing an electron donor material and PCBM as the electron acceptor material. The P1 in Example 1 was used as the electron donor material. The electron acceptor material is [6,6]-phenyl-C₆₁-butyric acid methyl ester (abbreviated PCBM). ITO is the indium tin oxide with a sheet resistance of 10-20 Ω/sq; PEDOT is poly (3,4 - ethylenedioxy-thiophene), the PSS is poly (styrene sulfonic acid); preferably the ITO with a sheet resistance of 18 Ω/sq.

The organic solar cell device was prepared according to the following steps:

An indium-tin oxide (ITO) layer 12 with a sheet resistance of 10-20Ω/sq was deposited on a surface of a glass substrate 11, a conductive layer as the anode was formed with a thickness of about 50 to 300 nm;

The ITO glass was subjected to ultrasonic cleaning and oxygen-Plasma processing, a PEDOT: PSS layer 13 having a thickness of 20 to 300 nm was coated on a surface of the ITO.

An active layer 14 having a thickness of the 50-300 nm was coated on the poly (3,4 - ethylenedioxy thiophene): PSS poly (styrene sulfonic acid) layer by the spin coating technique, the material of the active layer 14 is a mixture containing P1 in Example 1 and [6,6]-phenyl-C₆₁-butyric acid methyl ester (abbreviated PCBM);

Aluminum was vacuum deposited on a surface of the active layer to form a metal aluminum layer as a cathode; the organic solar battery device is obtained.

The organic solar cell device was encapsulated with an epoxy resin, placed in a sealed condition under 110°C for annealing for 1.5 hours, and then cooled to room temperature. After the annealing of the device, the chemical structure of the material became more regular and orderly, thus improving the transmission speed and efficiency of the carrier, and improving the photoelectric conversion efficiency of the device.

The preferred thickness of the ITO, PEDOT:PSS layer, active layer, A1 layer are 150nm, 50nm, 120nm, 100nm, respectively.

Example 7

An organic electroluminescent device is disclosed using P1 of Example 1.

An organic electroluminescent device had a structure shown in FIG. 2. In the organic solar cell device, the substrate was ITO glass, in which glass was used as substrate base, ITO as the conductive layer.

The structure of the organic electroluminescent device was shown as: glass 21/ ITO layer 22/luminescent layer 23/LiF buffer layer 24/Al layer 25, where the luminescent layer was made of P1 in Example 1.
The organic electroluminescent device was prepared according to the following steps:

An indium-tin oxide (ITO) layer 22 with a sheet resistance of 10-20Ω/sq was deposited on a surface of a glass substrate 21, a conductive layer as the anode was formed with a thickness of about 50 to 300 nm; the ITO preferably had a sheet resistance of 10Ω/sq.

A luminescent layer 23 made of P1 in Example 1 having a thickness of the 50-300 nm was coated on the ITO by the spin coating technique.

LiF having a thickness about 0.3 to 2 nm was vacuum deposited on the luminescent layer as the buffer layer 14.

Al was vacuum deposited on the luminescent layer as the Al layer 25 for cathode, and the organic electroluminescent device is obtained.

Example 8

An organic field effect transistor is disclosed using P1 of Example 1

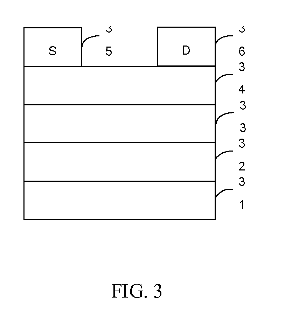

An organic field effect transistor had a structure shown in FIG. 3. The substrate use doping silicon (Si) as the substrate.

The structure of the organic field effect transistor was shown as: Si 31/SiO₂ insulation layer having a thickness of 440nm/octadecyltrichlorosilane (OTS) layer 33 for modifying SiO₂/organic semiconductor layer 34/source electrode (S) 35 made of gold and drain electrode (D) 36, where the material of the organic semiconductor layer 34 was made of P1 in Example 1. The material of the source electrode (S) and drain electrode (D) may be copper.

The organic field effect transistor was prepared according to the following steps:

Firstly, a SiO₂ insulation layer 32 was coated on a surface of the cleaned doping silicon 31; then, the octadecyltrichlorosilane layer 33 with a thickness of 10 to 200nm for modification was coated on the SiO₂ insulation layer; next, an organic semiconductor layer 34 made of P1 in Example 1 with a thickness of 5030 to 300nm was spin-coated on the octadecyltrichlorosilane layer; finally, the source electrode (S) 35 and drain electrode (D) 36 made of gold but not limited to gold were interval arranged on the organic semiconductor layer, and the organic field effect transistor was obtained.

Although the invention has been described in language specific to structural features and/or methodological acts, it is to be understood that the invention defined in the appended claims is not necessarily limited to the specific features or acts described. Rather, the specific features and acts are disclosed as sample forms of implementing the claimed invention.

## Claims

1. A fluorene-containing organic semiconductor material, represented by the following formula (P): 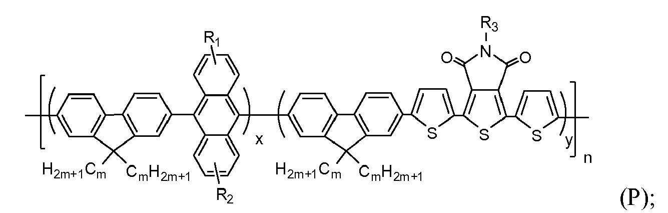 wherein n is an integer of 1-100; m is an integer of 1-20;
x and y are positive real numbers, and x + y = 1;
R₁ and R₂ are respectively H, F, CN group, C₁-C₄₀ straight or branched alkyl or alkoxyl, aryl or heteroaryl groups; R₃ is H or C₁-C₂₀ alkyl.

2. The fluorene-containing organic semiconductor material according to claim 1, wherein m is an integer of 6-12; R₁ and R₂ are C₁-C₁₈ linear or branched alkyl or alkoxyl; R₃ is C₁-C₁₂ alkyl.

3. A preparation method of a fluorene-containing organic semiconductor material, comprising the following steps:
mixing 2,7 - bis (4,4,5,5 - tetramethyl-1 ,3,2 - dioxaborolanyl) -9,9 - dialkyl fluorene represented by 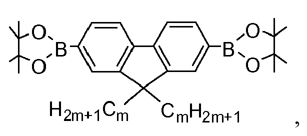 9,10-dibromoanthracene or derivatives thereof represented by 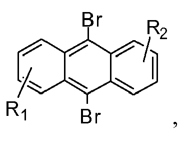 and 1,3-bis (5-bromo-thiophene-yl) - thieno [3,4-c] pyrrol-4, 6-dione and derivatives thereof represented by 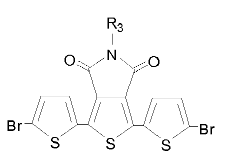 according to a mole ratio of i:j:k in the oxygen-free environment, wherein i=j+k; and i, j, k are positive real numbers, and
performing a Suzuki reaction for 24 to 72 hours at a temperature from 70°C to 100°C in the presence of catalyst, alkali solution, and a first solvent, and obtaining the fluorene-containing organic semiconductor material represented by the following formula: 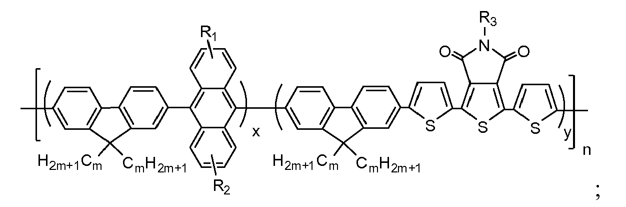
wherein n is an integer of 1-100; m is an integer of 1-20;
x and y are positive real numbers, and x + y = 1;
R₁ and R₂ are respectively H, F, cyano group, C₁-C₄₀ straight or branched alkyl or alkoxyl, aryl or heteroaryl groups; R₃ is H or C₁-C₂₀ alkyl.

4. The method according to claim 3, wherein m is an integer of 6-12; R₁ and R₂ are C₁-C₁₈ linear or branched alkyl or alkoxyl; R₃ is C₁-C₁₂ alkyl.

5. The method according to claim 3, further comprising a step of preparing the 2, 7 - bis (4,4,5,5 - tetramethyl-1 ,3,2 - dioxaborolanyl) -9,9 - dialkyl fluorene, wherein the step comprises: adding 2, 7 - dibromo-9, 9 - dialkyl fluorene represented by 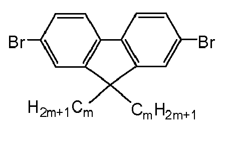 and n-butyl lithium into a second solvent according to a mole ratio of 1:2 to 1:4 under anhydrous and anaerobic conditions at a temperature from -70°C to -85°C, and adding bis(pinacolato)diboron represented by 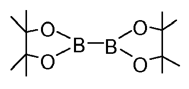 or 2 - isopropoxy-4, 4, 5, 5 - tetramethyl-1, 3, 2- dioxaborolane represented by 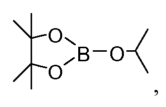 and performing a condensation reaction for 12 to 48 hours to obtain the 2,7 - bis (4,4,5,5 - tetramethyl-1 ,3,2 - dioxaborolanyl) -9,9 - dialkyl fluorene represented by

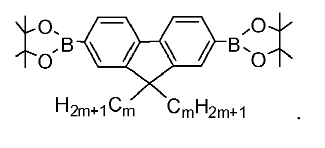

6. The method according to claim 5, wherein the second solvent is at least one selected from the group consisting of tetrahydrofuran, diethyl ether, dichloromethane, chloroform, and ethyl acetate, the mole amount of the bis(pinacolato)diboron or 2 - isopropoxy-4, 4, 5, 5 - tetramethyl-1, 3, 2- dioxaborolane is 2 to 4 times of the mole amount of the 2, 7 - dibromo-9, 9 - dialkyl fluorene.

7. The method according to claim 3, wherein the mole amount of the catalyst is 0.01 % to 20% of the mole amount of the 2, 7 - bis (4,4,5,5 - tetramethyl-1 ,3,2 - dioxaborolanyl) -9,9 - dialkyl fluorene;
the catalyst is organic palladium or a mixture of the organic palladium and organophosphorus ligand;
the organic palladium is Pd(PPh₃)₄, Pd(OAc)₂, Pd₂(dba)₃ or Pd(PPh₃)₂Cl₂;
the organophosphorus ligand is tricyclohexylphosphine or P(*o*-Tol)₃.

8. The method according to claim 7, in the mixture of the organic palladium and organophosphorus ligand, the mole ratio of the organic palladium to organophosphorus ligand is 1:1 to 1:20.

9. The method according to claim 3, wherein the alkali solution is NaOH aqueous solution, Na₂CO₃ aqueous solution, NaHCO₃aqueous solution, or tetraethyl ammonium hydroxide aqueous solution; the mole amount of the alkali solution is 2 to 20 times of the mole amount of the 2, 7 - bis (4,4,5,5 - tetramethyl-1 ,3,2 - dioxaborolanyl) -9,9 - dialkyl fluorene; the first solvent is at least one selected from the group consisting of toluene, ethylene glycol dimethyl ether, tetrahydrofuran, diethyl ether, dichloromethane, chloroform, and ethyl acetate.

10. A use of the fluorene-containing organic semiconductor material according to claim 1 in the field of organic solar cell, organic electroluminescent devices, organic field effect transistor, an organic optical storage, organic non-linear device, and the organic laser devices, etc..
